# EUROPÄISCHE PATENTANMELDUNG

(11) **EP 0 887 648 A2**
(43) Veröffentlichungstag der Anmeldung: **30.12.1998**
(21) Anmeldenummer: 98111631.2
(22) Anmeldetag: 24.06.1998
(51) Int. Cl.: G01R 19/165, G01R 15/06, B60L 9/30

(54) **Diskriminatorschaltung zur Unterscheidung von Hochspannungs-Gleichspannung und Hochspannungs-Wechselspannung**

(30) Priorität: 26.06.1997 DE 19727218
(71) Anmelder: SIEMENS AKTIENGESELLSCHAFT, 80333 München (DE)
(72) Erfinder: Schaller, Stephan, Dipl.-Ing., 91056 Erlangen (DE)

(57) **Zusammenfassung**

Die vorliegende Erfindung betrifft eine Diskriminatorschaltung zur Unterscheidung von Hochspannungs-Gleichspannung und Hochspannungs-Wechselspannung mit folgenden Merkmalen:
- die Diskriminatorschaltung weist einen ersten Festwiderstand (7), einen zweiten Festwiderstand (8), eine induktive Last (9) und ein Niederspannungs-Schaltelement (3) mit zwei Eingangsanschlüssen (10,11), einem Ausgabekanal (2,4) und einem Einstellelement (12) auf,
- eine aus dem ersten Festwiderstand (7), dem zweiten Festwiderstand (8) und der induktiven Last (9) bestehende Reihenschaltung ist einerseits mit einem Bezugspotential und andererseits mit einem gegenüber dem Bezugspotential Hochspannung führenden Leiter (6) verbunden,
- das Niederspannungs-Schaltelement (3) ist mit seinen Eingangsanschlüssen (10,11) parallel zu dem ersten Festwiderstand (7) geschaltet,
- der Ausgabekanal (2,4) wird umgeschaltet, wenn eine über dem ersten Festwiderstand (7) abfallende Ansteuerspannung (U) eine Schaltschwelle (U₀) überschreitet,
- die Schaltschwelle (U₀) ist mittels des Einstellelements (12) einstellbar.

## Beschreibung

Die vorliegende Erfindung betrifft eine Diskriminatorschaltung zur Unterscheidung von Hochspannungs-Gleichspannung und Hochspannungs-Wechselspannung.

Bei Hochspannungsstromkreisen ist es erforderlich, mittels einer Diskriminatorschaltung zu detektieren, mit welcher Spannung der Hochspannungsstromkreis mit Strom versorgt wird, da eine Überspannung zerstörende Wirkung haben könnte. Ferner muß Gleich- von Wechselspannung unterschieden werden können.

Im Stand der Technik ist eine Reihenschaltung bekannt, die aus einem Festwiderstand und einem Potentiometer besteht und einerseits mit einem Bezugspotential und andererseits mit einem gegenüber dem Bezugspotential Hochspannung führenden Leiter verbunden ist. Parallel zu dem Festwiderstand ist ein Relais angeordnet, dessen einer Eingangsanschluß mit dem von dem Potentiometer abgewandten Ende des Festwiderstands und dessen anderer Eingangsanschluß mit dem Schleifkontakt des Potentiometers verbunden ist. Durch Verstellen des Schleifkontakts des Potentiometers wird eingestellt, bei welcher Leitorspannung das Relais schaltet und so über seine Schaltanschlüsse das Überschreiten einer bestimmten Hochspannung anzeigt. Aufgrund der Anzeige können dann weitere Maßnahmen ergriffen werden, insbesondere Stromkreise mit dem Leiter verbunden bzw. von ihm getrennt werden.

Die Diskriminatorschaltung des Standes der Technik ist insofern nachteilig, als sowohl der Festwiderstand als auch das Potentiometer und das Relais hochspannungsfest sein müssen. Die genannten Teile sind folglich teuer. Ferner dürfen sie, wenn sie unter Spannung stehen könnten, nur von speziell ausgebildetem Personal gewartet und bedient werden. Dies ist insbesondere bei der Einstellung des Potentiometers der Fall. Darüber hinaus kann nicht zwischen Gleich- und Wechselspannung unterschieden werden.

Aus der DD 298 161 A5 ist eine Meßschaltung zur Messung von Hochspannungen bekannt, die einen ersten Festwiderstand, einen zweiten Festwiderstand und ein Einstellelement aufweist. Eine aus dem ersten Festwiderstand und dem zweiten Festwiderstand bestehende Reihenschaltung ist einerseits mit einem Bezugspotential und andererseits mit einem gegenüber dem Bezugspotential Hochspannung führenden Leiter verbunden. Das Übersetzungsverhältnis des Meßteilers ist mittels des Einstellelements einstellbar.

Aus der DE 38 04 381 C2 ist eine Meßschaltung zur Messung von Hochspannungen bekannt, die einen ersten Festwiderstand, einen zweiten Festwiderstand und ein Anzeigeelement mit zwei Eingangsanschlüssen, einem Ausgabekanal und einem Einstellelement aufweist. Eine aus dem ersten Festwiderstand und dem zweiten Festwiderstand bestehende Reihenschaltung ist einerseits mit einem Bezugspotential und andererseits mit einem gegenüber dem Bezugspotential Hochspannung führenden Leiter verbunden. Das Anzeigeelement ist mit seinen Eingangsanschlüssen parallel zu dem ersten Festwiderstand geschaltet. Der Ausgabekanal wird entsprechend dem Eingangssignal analog angesteuert. Das Übersetzungsverhältnis ist mittels des Einstellelements einstellbar.

Aus der DD 274 964 A3 ist eine Anzeigeschaltung zur Anzeige von Hochspannungen bekannt, die einen ersten Festwiderstand, einen zweiten Festwiderstand und ein Anzeigeelement mit zwei Eingangsanschlüssen, einem Ausgabekanal und einem Einstellelement aufweist. Eine aus dem ersten Festwiderstand und dem zweiten Festwiderstand bestehende Reihenschaltung ist einerseits mit einem Bezugspotential und andererseits mit einem gegenüber dem Bezugspotential Hochspannung führenden Leiter verbunden. Das Anzeigeelement ist mit seinen Eingangsanschlüssen parallel zu dem ersten Festwiderstand geschaltet. Der Ausgabekanal wird entsprechend dem Eingangssignal analog angesteuert. Das Übersetzungsverhältnis ist mittels des Einstellelements einstellbar.

Aus der DE 35 29 384 A1 ist eine Diskriminatorschaltung zur Unterscheidung unterschiedlicher Spannungen bekannt, die zwei erste Festwiderstände, zwei zweite Festwiderstände und ein Schaltelement mit zwei Eingangsanschlüssen und einem Ausgabekanal aufweist. Aus je einem ersten Festwiderstand und je einem zweiten Festwiderstand bestehende Reihenschaltungen sind einerseits mit einem Bezugspotential und andererseits mit einem gegenüber dem Bezugspotential Spannung führenden Leiter verbunden. Das Schaltelement ist mit seinen Eingangsanschlüssen als Brücke zwischen die beiden Reihenschaltungen geschaltet. Der Ausgabekanal wird umgeschaltet, wenn eine über dem Schaltelement abfallende Steuerspannung eine Schaltschwelle überschreitet.

Die Aufgabe der vorliegenden Erfindung besteht darin, eine Diskriminatorschaltung zur Unterscheidung von Hochspannungs-Gleichspannung und Hochspannungs-Wechselspannung zur Verfügung zu stellen, die mit möglichst kostengünstigen Bauelementen auskommt und bei der die Einstellung der Schaltschwelle, bei der das Niederspannungs-Schaltelement schaltet, von weniger qualifiziertem Personal vorgenommen werden kann.

Die Aufgabe wird durch eine Diskriminatorschaltung mit folgenden Merkmalen gelöst:
- die Diskriminatorschaltung weist einen ersten Festwiderstand, einen zweiten Festwiderstand, eine induktive Last und ein Niederspannungs-Schaltelement mit zwei Eingangsanschlüssen, einem Ausgabekanal und einem Einstellelement auf,
- eine aus dem ersten Festwiderstand, dem zweiten Festwiderstand und der induktiven Last bestehende Reihenschaltung ist einerseits mit einem Bezugspotential und andererseits mit einem gegenüber dem Bezugspotential Hochspannung führenden Leiter verbunden,
- das Niederspannungs-Schaltelement ist mit seinen Eingangsanschlüssen parallel zu dem ersten Festwiderstand geschaltet,
- der Ausgabekanal wird umgeschaltet, wenn eine über dem ersten Festwiderstand abfallende Ansteuerspannung eine Schaltschwelle überschreitet,
- die Schaltschwelle ist mittels des Einstellelements einstellbar.

Die Weiterverarbeitung des von dem Niederspannungs-Schaltelement ausgegebenen Signals ist besonders einfach, wenn der Ausgabekanal von den Eingangsanschlüssen elektrisch getrennt ist. Dies ist beispielsweise der Fall, wenn das Niederspannungs-Schaltelement als Optokoppler ausgebildet ist. Das Niederspannungs-Schaltelement kann aber auch als Relais ausgebildet sein.

Das Einstellelement ist besonders einfach, zuverlässig und kostengünstig, wenn es als Niederspannungs-Potentiometer ausgebildet ist. Dies ist insbesondere dann vorteilhaft, wenn das Niederspannungs-Schaltelement als Relais ausgebildet ist, da es kommerziell erhältliche Relais gibt, bei denen die Schaltschwelle mittels eines in das Relais integrierten Potenciometers verstellbar ist.

Zum Schutz des Niederspannungs-Schaltelements vor Überspannung ist ihm vorzugsweise eine Überspannungsschutzschaltung zugeordnet. Die Überspannungsschutzschaltung kann dabei wahlweise als dem Niederspannungs-Schaltelement parallelgeschalteter Varistor oder als dem Niederspannungs-Schaltelement parallelgeschaltete Zenerdiodenschaltung ausgebildet sein. Bei Verwendung eines Varistors bricht bei einer Überspannung die Spannung an den Betätigungsanschlüssen des Niederspannungs-Schaltelements zusammen. Folglich schaltet das Niederspannungs-Schaltelement ab. Zenerdioden hingegen begrenzen nur die Spannung am Niederspannungs-Schaltelement.

Die Diskriminatorschaltung kann insbesondere bei einer Elektrolok zur Erkennung einer Versorgungsspannung verwendet werden.

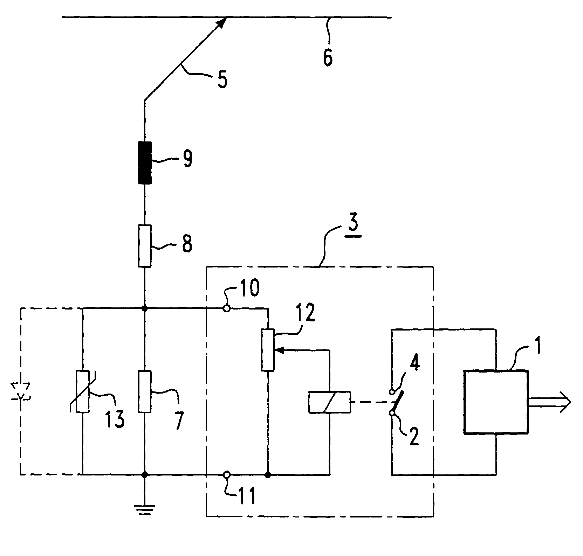

Weitere Vorteile und Einzelheiten ergeben sich aus der nachfolgenden Beschreibung eines Ausführungsbeispiels. Dabei zeigt in Prinzipdarstellung
- FIG 1: eine Diskriminatorschaltung.

Gemäß FIG 1 steuert eine Steuerschaltung 1 Schaltelemente an, mittels derer Stromkreise an einen Leiter 6 angeschlossen oder von ihm getrennt werden, der gegenüber dem Erdpotential als Bezugspotential Hochspannung führt. Der Begriff 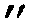 Hochspannung" wird für Spannungen über 1 kV verwendet. Das Anschließen bzw. Trennen erfolgt je nachdem, wie hoch die Hochspannung des Leiters 6 ist und ob es sich um Gleich- oder Wechselspannung handelt. Sowohl die Schaltelemente als auch die Stromkreise sind in FIG 1 der Übersichtlichkeit halber nicht dargestellt.

Der Leiter 6 entspricht dem Fahrdraht 6 einer Bahnstromversorgung, der über einen Stromabnehmer 5 mit der Diskriminatorschaltung verbunden ist. Der Fahrdraht 6 kann eine der folgenden vier Spannungen führen:
- 1,5 kV Gleichspannung,
- 3 kV Gleichspannung,
- 15 kV, 16 2/3 Hz Wechselspannung oder
- 25 kV, 50 Hz Wechselspannung.

Alle Spannungen dürfen um maximal 30 % nach oben oder unten schwanken.

Die Diskriminatorschaltung weist einen ersten Festwiderstand 7 und einen zweiten Festwiderstand 8 auf, die in Reihe geschaltet sind. Der Begriff 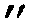 Festwiderstand" wird dabei im Gegensatz zu einem einstellbaren Widerstand (= Potentiometer) verwendet. Der erste Festwiderstand 7 hat einen Widerstand von 4 kΩ, der zweite Festwiderstand 8 einen Widerstand von 46 kΩ.

Zur Unterscheidung von Hochspannungs-Gleichspannung und Hochspannungs-Wechselspannung ist den Festwiderständen 7,8 eine induktive Last 9 vorgeschaltet. Die induktive Last 9 ist ein Spezialmeßwandler mit einem ohmschen Widerstand von 18 kΩ und einer Induktivität von 60 kH. Der Spezialmeßwandler wird benötigt, um gegebenenfalls auswerten zu können, welche Wechselspannung der Fahrdraht 6 führt. Im Rahmen der vorliegenden Erfindung ist dies jedoch ohne Belang, so daß auf eine weitergehende Beschreibung des Spezialmeßwandlers verzichtet wird.

Die so gebildete Reihenschaltung ist einerseits mit Erde und andererseits mit dem Leiter 6 verbunden. Ein Niederspannungs-Schaltelement 3 ist mit zwei Eingangsanschlüssen 10,11 parallel zu dem ersten Festwiderstand 7 geschaltet. Das Niederspannungs-Schaltelement 3 ist im vorliegenden Fall als Relais 3 ausgebildet. Das Niederspannungs-Schaltelement 3 verbindet Ausgabeanschlüsse 2,4 miteinander und gibt über den so gebildeten Ausgabekanal 2,4 ein Ausgabesignal an die Steuerschaltung 1 aus, wenn über den Eingangsanschlüssen 10,11 - bzw. dem ersten Festwiderstand 7 - eine Ansteuerspannung U abfällt, die eine Schaltschwelle U₀ überschreitet.

Zum Einstellen der Schaltschwelle U₀ weist das Niederspannungs-Schaltelement 3 ein Einstellelement 12 auf, im einfachsten Fall ein Niederspannungs-Potentiometer 12. Mittels des Einstellelements 12 ist die Schaltschwelle U₀ innerhalb weiter Grenzen einstellbar.

Zum Schutz des Niederspannungs-Schaltelements 3 vor einer Überspannung weist die Diskriminatorschaltung ferner eine Überspannungsschutzschaltung 13 auf. Sie ist im vorliegenden Fall als dem Niederspannungs-Schaltelement 3 parallelgeschalteter Varistor 13 ausgebildet. Alternativ könnte die Überspannungsschutzschaltung 13 aber auch, wie in FIG 1 gestrichelt dargestellt, als dem Niederspannungs-Schaltelement 3 parallelgeschaltete Zenerdiodenschaltung ausgebildet sein.

Mit den obigen Zahlenwerten für die Widerstände 7,8 und die Induktivität 9 ergibt sich:
a) Bei der minimalen Gleichspannung von 0,7 x 1,5 kV = 1,05 kV fällt über dem ersten Festwiderstand 7 eine Ansteuerspannung U ≈ 60 V, bei der maximalen Gleichspannung von 1,3 x 3 kV = 3,9 kV eine Ansteuerspannung U ≈ 230 V ab;
b) Bei einer Wechselspannungsfrequenz von 50 Hz fällt bei der minimalen Wechselspannung von 0,7 x 25 kV = 17,5 kV eine Ansteuerspannung U ≈ 3,7 V, bei der maximalen Wechselspannung von 1,3 x 25 kV = 32,5 kV eine Ansteuerspannung U ≈ 6,9 V ab;
c) Bei einer Wechselspannungsfrequenz von 16 2/3 Hz fällt bei der minimalen Wechselspannung von 0,7 x 15 kV = 10,5 kV eine Ansteuerspannung U ≈ 6,7 V, bei der maximalen Wechsel-spannung von 1,3 x 15 kV = 19,5 kV eine Ansteuerspannung U ≈ 12,4 V ab.

Um das gewünschte Ausgabeverhalten zu zeigen, also
- die Ausgabeanschlüsse 2,4 miteinander zu verbinden, wenn der Fahrdraht 6 Gleichspannung führt, und
- die Ausgabeanschlüsse 2,4 voneinander zu trennen, wenn der Fahrdraht 6 Wechselspannung führt,
muß die Schaltschwelle U₀ folglich zwischen 12,4 V und 60 V eingestellt werden, vorzugsweise zwischen 20 und 40 V.

Praktische Bedeutung hat die obenstehend beschriebene Diskriminatorschaltung insbesondere bei einer Mehrsystem-Elektrolok.

## Patentansprüche

1. Diskriminatorschaltung zur Unterscheidung von Hochspannungs-Gleichspannung und Hochspannungs-Wechselspannung mit folgenden Merkmalen:
- die Diskriminatorschaltung weist einen ersten Festwiderstand (7), einen zweiten Festwiderstand (8), eine induktive Last (9) und ein Niederspannungs-Schaltelement (3) mit zwei Eingangsanschlüssen (10,11), einem Ausgabekanal (2,4) und einem Einstellelement (12) auf,
- eine aus dem ersten Festwiderstand (7), dem zweiten Festwiderstand (8) und der induktiven Last (9) bestehende Reihenschaltung ist einerseits mit einem Bezugspotential und andererseits mit einem gegenüber dem Bezugspotential Hochspannung führenden Leiter (6) verbunden,
- das Niederspannungs-Schaltelement (3) ist mit seinen Eingangsanschlüssen (10,11) parallel zu dem ersten Festwiderstand (7) geschaltet,
- der Ausgabekanal (2,4) wird umgeschaltet, wenn eine über dem ersten Festwiderstand (7) abfallende Ansteuerspannung (U) eine Schaltschwelle (U₀) überschreitet,
- die Schaltschwelle (U₀) ist mittels des Einstellelements (12) einstellbar.

2. Diskriminatorschaltung nach Anspruch 1,
**dadurch gekennzeichnet,**
daß der Ausgabekanal (2,4) von den Eingangsanschlüssen (10,11) elektrisch getrennt ist.

3. Diskriminatorschaltung nach Anspruch 2,
**dadurch gekennzeichnet**,
daß das Niederspannungs-Schaltelement (3) als Relais (3) ausgebildet ist.

4. Diskriminatorschaltung nach Anspruch 1, 2 oder 3,
**dadurch gekennzeichnet,**
daß das Einstellelement (12) als Niederspannungs-Potentiometer (12) ausgebildet ist.

5. Diskriminatorschaltung nach Anspruch 1, 2, 3 oder 4,
**dadurch gekennzeichnet,**
daß dem Niederspannungs-Schaltelement (3) eine Überspannungsschutzschaltung (13) zugeordnet ist.

6. Diskriminatorschaltung nach Anspruch 5,
**dadurch gekennzeichnet,**
daß die Überspannungsschutzschaltung (13) als dem Niederspannungs-Schaltelement (3) parallelgeschalteter Varistor (13) ausgebildet ist.

7. Diskriminatorschaltung nach Anspruch 5,
**dadurch gekennzeichnet,**
daß die Überspannungsschutzschaltung (13) als dem Niederspannungs-Schaltelement (3) parallelgeschaltete Zenerdiodenschaltung ausgebildet ist.

8. Diskriminatorschaltung nach einem der Ansprüche 1 bis 7,
**dadurch gekennzeichnet,**
daß sie bei einer Elektrolok zur Erkennung einer Versorgungsspannung verwendet wird.
